# EUROPÄISCHE PATENTSCHRIFT

(11) **EP 2 770 640 B1**
(45) Veröffentlichungstag und Bekanntmachung des Hinweises auf die Patenterteilung: **27.03.2019**
(21) Anmeldenummer: 14000528.1
(22) Anmeldetag: 13.02.2014
(51) Int. Cl.: H03K 17/965

(54) **Bedienvorrichtung, insbesondere für ein elektronisches Haushaltsgerät**
Operating device, in particular for an electric domestic appliance
Dispositif de commande, notamment pour un appareil ménager électronique

(30) Priorität: 22.02.2013 DE 102013003072
(43) Veröffentlichungstag der Anmeldung: 27.08.2014
(73) Patentinhaber: Diehl AKO Stiftung & Co. KG, 88239 Wangen (DE)
(72) Erfinder: Heimann, Uwe, 88239 Wangen (DE)
(74) Vertreter: Diehl Patentabteilung

(56) Entgegenhaltungen:
- EP-A1- 1 786 107
- EP-A2- 1 740 033
- WO-A1-2008/022883
- DE-A1-102010 036 237
- FR-A1- 2 704 332

## Beschreibung

Die vorliegende Erfindung betrifft eine Bedienvorrichtung, insbesondere eine Bedienvorrichtung für ein elektronisches Haushaltsgerät, sowie ein elektronisches Haushaltsgerät, insbesondere ein wasserführendes elektronisches Haushaltsgerät mit einer solchen Bedienvorrichtung.

Im Stand der Technik sind zahlreiche Bedienvorrichtungen mit berührungs- oder annäherungsempfindlichen Bedienelementen bekannt, darunter insbesondere auch solche mit kapazitiven Bedienelementen. Im Fall eines kapazitiven Bedienelements oder Berührungsschalters bildet üblicherweise ein kapazitives Sensorelement zusammen mit dem Finger eines Benutzers über eine als Dielektrikum wirkende Blende eine Kapazität, die entsprechend dem Betätigen des Berührungsschalters, d.h. dem Berühren oder Nichtberühren bzw. Annähern eines dem kapazitiven Sensorelement zugeordneten Berührungsfeldes auf der Blende variabel ist. Die Veränderung der Kapazität wirkt sich entsprechend auf ein Ausgangssignal der Sensorschaltung aus, was von einer angeschlossenen Auswerteschaltung entsprechend als eine Betätigung des kapazitiven Berührungsschalters ausgewertet werden kann.

Die Funktionsfähigkeit solcher kapazitiver Berührungsschalter ist verbessert, wenn gewährleistet werden kann, dass das kapazitive Sensorelement an der Blende anliegt, d.h. möglichst keine Luftspalte zwischen der Blende und dem Sensorelement existieren, welche das Dielektrikum der Kapazität verändern würden. Dabei ist es wünschenswert, dass diese Funktionsfähigkeit auch bei Temperaturänderungen, Einbau- und Fertigungstoleranzen und dergleichen erzielt wird.

Es ist zu diesem Zweck zum Beispiel aus der EP 0 859 467 B1 bekannt, das kapazitive Sensorelement aus einem Körper aus einem in sich flexiblen, räumlich ausgedehnten, raumformveränderlichen und elektrisch leitfähigen Material wie beispielsweise weichelastischem Kunststoff oder Schaumstoff mit eingelagerten, elektrisch leitfähigen Partikeln zu bilden, sodass der Körper den Abstand zwischen der Leiterplatte und der Blende unter einer aufrechterhaltenen Druckspannung überbrücken kann.

Die DE 10 2005 053 792 A1 offenbart einen kapazitiven Berührungsschalter für ein Bedienfeld eines elektrischen Haushaltsgerätes, dessen kapazitives Sensorelement eine Druckfeder und ein Kontaktelement jeweils aus einem elektrisch leitenden Material aufweist, sodass das Kontaktfeld, welches in Form und Größe an das Berührungsfeld der Blende angepasst werden kann, durch die sich gegen die Leiterplatte abstützende Druckfeder elektrisch kontaktiert und gegen die Unterseite der Blende gedrückt wird.

Die EP 1 740 033 A2 offenbart ein elektronisches Steuergerät für elektrische Geräte, auf dem der Oberbegriff des Anspruchs 1 basiert.

Bei verschiedenen Anwendungen, wie beispielsweise bei wasserführenden Haushaltsgeräten (z.B. Waschmaschinen, Wäschetrockner, Spülmaschinen und dergleichen), besteht zudem Bedarf, die Elektronik solcher Bedienvorrichtungen zu schützen.

Es ist daher eine Aufgabe der Erfindung, eine Bedienvorrichtung mit kapazitiven Bedienelementen vorzusehen, welche unter Beibehaltung einer verbesserten Funktionsfähigkeit auch einen verbesserten Schutz ihrer Elektronik ermöglicht.

Diese Aufgabe wird gelöst durch eine Bedienvorrichtung mit den Merkmalen des Anspruchs 1. Besonders bevorzugte Ausgestaltungen und Weiterbildungen der Erfindung sind Gegenstand der abhängigen Ansprüche.

Bei der erfindungsgemäßen Bedienvorrichtung sind die wenigstens eine Leiterplatte und die elektrische Kontaktierung des kapazitiven Sensorelements innerhalb eines Gehäuses und damit geschützt angeordnet. Die erfindungsgemäße Bedienvorrichtung kann daher in vorteilhafter Weise auch bei wasserführenden Haushaltsgeräten eingesetzt werden.

Trotz der Kapselung der Elektronik in dem Gehäuse ist bei der erfindungsgemäßen Bedienvorrichtung die Funktionsfähigkeit des kapazitiven Berührungsschalters gewährleistet, da nur der Kontaktabschnitt des Sensorelements in das Gehäuse hinein ragt, während ein Kopfabschnitt des Sensorelements außerhalb des Gehäuses der Blende zugewandt angeordnet ist, das Sensorelement relativ zum Gehäuse bewegbar in diesem gehalten ist und schließlich das Sensorelement und damit insbesondere auch sein Kopfabschnitt durch das Federelement in Richtung zur Blende vorgespannt sind, sodass der Kopfabschnitt des Sensorelements an der Innenseite der Blende möglichst ohne Luftspalte anliegt. Durch die bewegbare Anordnung des Sensorelements im/am Gehäuse können Einbau- und Fertigungstoleranzen ausgeglichen werden und so die Funktionsfähigkeit des kapazitiven Sensorelements gewährleistet werden.

Das Sensorelement weist einen Kopfabschnitt und einen Kontaktabschnitt auf. Der Kopfabschnitt und der Kontaktabschnitt des Sensorelements sind vorzugsweise einstückig ausgebildet, können aber auch in Form von zwei separat gefertigten und miteinander verbundenen Komponenten ausgestaltet sein.

Das Sensorelement ist zumindest teilweise aus einem elektrisch leitfähigen Material gefertigt. Das Sensorelement ist vorzugsweise aus einem Metall, einer Metalllegierung oder einem elektrisch leitfähigen Kunststoff gefertigt. In einer anderen Ausgestaltung kann das Sensorelement auch aus einem elektrisch isolierenden oder nur schlecht elektrisch leitenden Werkstoff gefertigt und mit einer Beschichtung, Ummantelung oder dergleichen aus einem elektrisch leitfähigen Material versehen sein. Der Kopfabschnitt des Sensorelements stellt eine elektrisch leitfähige Kontaktfläche an der Innenseite der Blende bereit, und der Kontaktabschnitt des Sensorelements dient der elektrisch leitenden Kontaktierung zur Leiterplatte (via Federelement).

Das Federelement ist zumindest teilweise aus einem elektrisch leitfähigen Material gefertigt. Das Federelement ist vorzugsweise aus einem Metall oder einer Metalllegierung gefertigt. In einer anderen Ausgestaltung kann das Sensorelement auch aus einem elektrisch isolierenden oder nur schlecht elektrisch leitenden Werkstoff gefertigt und mit einer Beschichtung, Ummantelung oder dergleichen aus einem elektrisch leitfähigen Material versehen sein. Das Federelement ist vorzugsweise in der Form einer Druckfeder bzw. Schraubendruckfeder ausgestaltet.

Das Federelement ist zwischen der elektrischen Kontaktfläche der Leiterplatte und dem Kontaktabschnitt des Sensorelements angeordnet. Das Federelement steht vorzugsweise mit der elektrischen Kontaktfläche und mit dem Kontaktabschnitt elektrisch leitend in Kontakt. Das Federelement ist vorzugsweise fest (z.B. verlötet, verklebt) oder lösbar mit der elektrischen Kontaktfläche und mit dem Kontaktabschnitt des Sensorelements verbunden oder berührt diese lose.

Die Bedieneinrichtung der Bedienvorrichtung ist vorzugsweise als ein Bedienmodul, d.h. eine vorzufertigende Baueinheit ausgebildet.

In einer bevorzugten Ausgestaltung der Erfindung ist die Bedienvorrichtung mit mehreren kapazitiven Bedienelementen bzw. Berührungsschaltern ausgestattet. D.h. die wenigstens eine Leiterplatte weist mehrere elektrische Kontaktflächen auf; es sind mehrere Sensorelemente vorgesehen, welche jeweils zumindest teilweise aus einem elektrisch leitfähigen Material ausgestaltet sind, wobei die Sensorelemente jeweils einen außerhalb des Gehäuses angeordneten Kopfabschnitt und einen durch eine Durchgangsöffnung in das Gehäuse hinein ragenden Kontaktabschnitt aufweisen, wobei die Sensorelemente jeweils relativ zum Gehäuse in Längsrichtung ihrer Kontaktabschnitte bewegbar sind; und es sind mehrere Federelemente vorgesehen, welche jeweils zumindest teilweise aus einem elektrisch leitfähigen Material ausgestaltet sind und jeweils zwischen einer elektrischen Kontaktfläche und dem Kontaktabschnitt eines Sensorelements angeordnet sind, um das jeweilige Sensorelement elektrisch leitend mit der Kontaktfläche zu verbinden und das Sensorelement in Richtung zur Blende vorzuspannen.

Die Sensorelemente sind über die ihnen zugeordneten Federelemente einzeln zur Blende hin vorgespannt. Auf diese Weise lassen sich unterschiedliche Einbau- und Fertigungstoleranzen an verschiedenen Stellen der Bedienvorrichtung ausgleichen. So lässt sich die Funktionsfähigkeit aller Bedienelemente gewährleisten.

Die Anzahlen der Sensorelemente, der Federelemente und der elektrischen Kontaktflächen sind vorzugsweise gleich gewählt. In einer anderen bevorzugten Ausgestaltung kann die wenigstens eine Leiterplatte auch mehr elektrische Kontaktflächen aufweisen, die nicht von einem Sensorelement kontaktiert werden.

Gemäß der Erfindung ist an dem Gehäuse wenigstens ein Vorsprung vorgesehen, welcher eine Durchgangsöffnung umlaufend in Richtung zur Blende vorsteht; und ist an dem Kopfabschnitt des Sensorelements ein umlaufender Vorsprung vorgesehen, welcher in Richtung zum Gehäuse vorsteht und in radialer Richtung innerhalb oder außerhalb des Vorsprunges am Gehäuse positioniert ist. Die Vorsprünge am Gehäuse und am Kopfabschnitt des Sensorelements greifen ineinander und bilden eine Art Labyrinthdichtung um die Durchgangsöffnung des Gehäuses herum. Im Fall von mehreren Bedienelementen sind vorzugsweise entsprechend alle Durchgangsöffnungen und alle Sensorelemente mit solchen Vorsprüngen versehen, um Labyrinthdichtungen zu bilden.

In einer bevorzugten Ausgestaltung der Erfindung weist das Gehäuse wenigstens ein erstes Rastelement auf und weist der Kontaktabschnitt des Sensorelements wenigstens ein zweites Rastelement auf, wobei das erste Rastelement mit dem zweiten Rastelement derart in Eingriff steht, dass das Sensorelement relativ zum Gehäuse in Längsrichtung seines Kontaktabschnitts bewegbar ist. Die miteinander in Eingriff stehenden ersten und zweiten Rastelemente bestimmen vorzugsweise den maximalen Hub des Sensorelements relativ zum Gehäuse und damit den maximal möglichen Toleranzausgleich. Im Fall von mehreren Bedienelementen sind vorzugsweise entsprechend alle Durchgangsöffnungen und alle Sensorelemente mit solchen ersten und zweiten Rastelementen versehen.

In einer bevorzugten Ausgestaltung ist auf der wenigstens einen Leiterplatte wenigstens ein Leuchtelement angeordnet und ist in dem Gehäuse wenigstens ein Lichtleiter angeordnet, welcher sich von dem Leuchtelement in Richtung zur Blende erstreckt. Das Leuchtelement weist vorzugsweise wenigstens eine Leuchtdiode (LED oder OLED) auf. Das Leuchtelement besitzt vorzugsweise eine veränderbare Eigenschaften (z.B. spektrale Charakteristik, Lichtstärke, Dauer-oder Blinklicht, etc.). Mit Hilfe des Leuchtelements können vorzugsweise die Position eines Berührungsfeldes eines kapazitiven Bedienelements und/oder ein Betriebszustand eines kapazitiven Bedienelements der Bedienvorrichtung gekennzeichnet werden. Im Fall von mehreren Bedienelementen sind vorzugsweise entsprechend mehrere Leuchtelemente und Lichtleiter vorgesehen.

Bevorzugt ist bei dieser Ausgestaltung das Leuchtelement neben einer elektrischen Kontaktfläche auf der Leiterplatte angeordnet und ist die Blende in einem Bereich neben dem Kopfabschnitt des Sensorelements zumindest teilweise lichtdurchlässig ausgebildet. D.h. das Leuchtelement und der Lichtleiter sind einem Sensorelement bzw. seinem Berührungsfeld auf der Blende zugeordnet.

In einer bevorzugten Ausgestaltung der Erfindung ist zudem wenigstens ein Anzeigeelement auf der dem Benutzer abgewandten Seite eines zumindest teilweise lichtdurchlässigen Bereichs der Blende angeordnet und mittels wenigstens eines weiteren Federelements in Richtung zur Blende vorgespannt. Das Anzeigeelement ist vorzugsweise als Display (z.B. LCD- oder LED-Technik) ausgestaltet.

Das Anzeigeelement ist bevorzugt zwischen dem Gehäuse und der Blende angeordnet.

Das weitere Federelement ist bevorzugt zumindest teilweise aus einem elektrisch leitfähigen Material ausgestaltet und stützt sich bevorzugt auf einer weiteren elektrischen Kontaktfläche der Leiterplatte ab, um das Anzeigeelement elektrisch leitend mit der Kontaktfläche zu verbinden.

Gegenstand der Erfindung ist auch ein elektronisches Haushaltsgerät, insbesondere ein wasserführendes elektronisches Haushaltsgerät, welches mit wenigstens einer oben beschriebenen Bedienvorrichtung der Erfindung ausgestattet ist. Bei dem wasserführenden elektronischen Haushaltsgerät handelt es sich vorzugsweise um eine Spülmaschine, eine Waschmaschine, einen Wäschetrockner oder dergleichen.

Obige sowie weitere Merkmale und Vorteile der Erfindung werden aus der nachfolgenden Beschreibung eines bevorzugten, nicht-einschränkenden Ausführungsbeispiele anhand der beiliegenden Zeichnung besser verständlich. Darin zeigen, zum Teil schematisch:
- Fig. 1: eine Perspektivansicht einer Bedienvorrichtung gemäß einem Ausführungsbeispiel der vorliegenden Erfindung;
- Fig. 2: eine perspektivische Explosionsdarstellung der Blende der Bedienvorrichtung von Figur 1;
- Fig. 3: eine perspektivische Explosionsdarstellung des Bedienmoduls der Bedienvorrichtung von Figur 1;
- Fig. 4: eine Querschnittsansicht des zusammengesetzten Bedienmoduls von Figur 3;
- Fig. 5: eine Teillängsansicht des zusammengesetzten Bedienmoduls von Figur 3;
- Fig. 6: eine perspektivische Teildraufsicht des zusammengesetzten Bedienmoduls von Figur 3;
- Fig. 7: eine Perspektivansicht eines Sensorelements des Bedienmoduls von Figur 3;
- Fig. 8: eine perspektivische Querschnittsansicht des zusammengesetzten Bedienmoduls von Figur 3; und
- Fig. 9: eine Perspektivansicht eines Displays des Bedienmoduls von Figur 3.

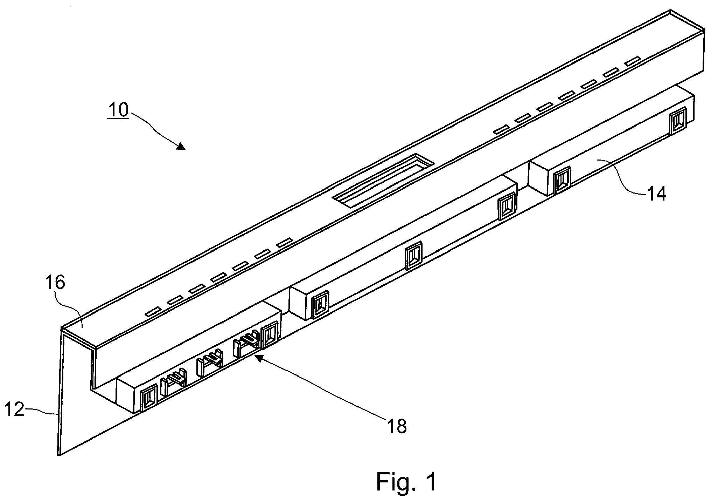

In den Figuren 1 bis 9 ist beispielhaft ein bevorzugtes Ausführungsbeispiel einer erfindungsgemäßen Bedienvorrichtung mit mehreren kapazitiven Bedienelementen für ein wasserführendes elektronisches Haushaltsgerät wie zum Beispiel eine Spülmaschine, eine Waschmaschine oder dergleichen dargestellt.

Die Bedienvorrichtung 10 weist eine Blende bzw. Bedienblende 12 auf, welche aus einem elektrisch isolierenden Material, beispielsweise einem Kunststoffmaterial, gefertigt ist. Auf der dem Benutzer abgewandten Innenseite dieser Blende 12 ist eine Bedieneinrichtung 14 angeordnet, welche bevorzugt als ein Bedienmodul, d.h. als eine bauliche Einheit konzipiert ist.

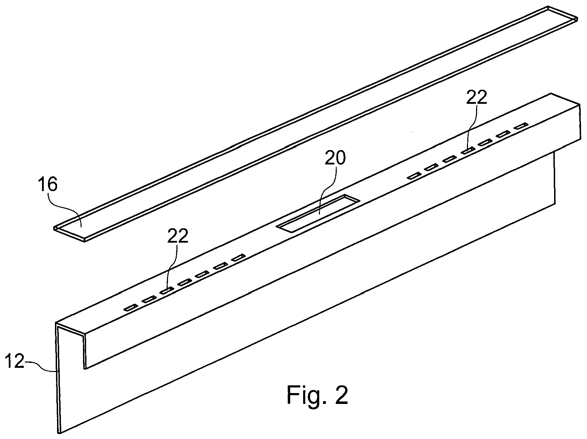

Auf der dem Benutzer zugewandten Außenseite der Blende 12 (oben in Fig. 1 und 2) ist optional eine Abdeckung 16 vorgesehen, zum Beispiel aufgeklebt, welche als Designelement dient. Die Abdeckung 16 ist ebenfalls aus einem elektrisch isolierenden Material, beispielsweise einem Kunststoffmaterial, gefertigt. Außerdem ist die Abdeckung 16 zumindest in Teilbereichen (teil-) lichtdurchlässig ausgebildet.

In Fig. 1 sind zudem mehrere elektrische Anschlüsse 18 der Bedieneinrichtung 14 erkennbar, mit denen diese zum Beispiel mit einer Gerätesteuerung, einer Stromversorgung, etc. verbunden werden kann.

Wie in Fig. 2 dargestellt, weist die Blende 12 eine mittige Öffnung bzw. Durchbrechung 20 sowie mehrere Öffnungen bzw. Durchbrechungen 22 auf. Anstelle der Öffnungen bzw. Durchbrechungen 20, 22 kann die Blende 12 an diesen Stellen auch geschlossen, aber lichtdurchlässig bzw. transparent ausgebildet sein. Die mittige Öffnung 20 ist für ein später beschriebenes Anzeigeelement bzw. Display 30 vorgesehen. Die Öffnungen 22 sind für Lichtleiter32 vorgesehen.

In anderen Ausführungsformen kann die Bedienvorrichtung 10 auch ohne Display ausgestaltet sein und die Blende 12 dementsprechend ohne die mittige Öffnung 20 ausgestaltet sein. Außerdem können die Öffnungen 20, 22 auch in anderen Anzahlen und Anordnungen vorgesehen sein, je nach Ausführungsform der verwendeten Bedieneinrichtung 14.

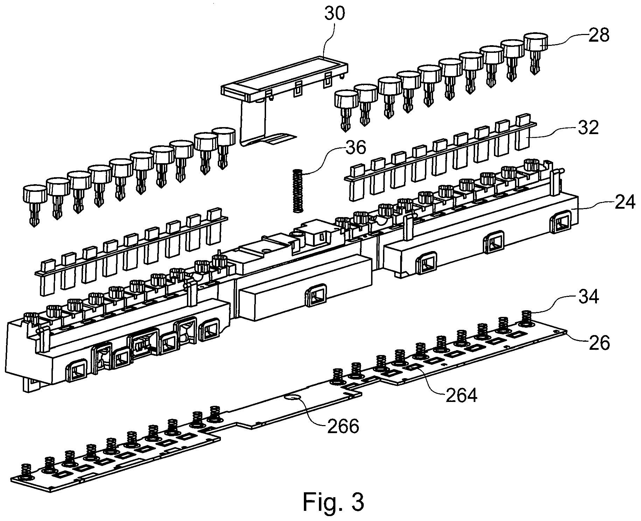

Fig. 3 bis 9 zeigen die Bedieneinrichtung 14 der Bedienvorrichtung 10 und ihre Komponenten in mehr Einzelheiten.

Die Bedieneinrichtung bzw. das Bedienmodul 14 enthält ein Gehäuse 24. Das Gehäuse 24 ist aus einem elektrisch isolierenden Material, beispielsweise einem Kunststoffmaterial, zum Beispiel als Spritzgussteil gefertigt. Das Gehäuse 24 kann dabei aus mehreren Gehäuseteilen zusammengesetzt sein.

Das Gehäuse 24 soll einen Schutz insbesondere der elektronischen Komponenten der Bedieneinrichtung 14 gewährleisten. Zu diesem Zweck ist das Gehäuse vorzugsweise spritzwasserdicht ausgestaltet und seine verschiedenen Anschluss- und Durchgangsöffnungen mit geeigneten Dichtungsmaßnahmen versehen.

In dem Gehäuse 24 ist wenigstens eine Leiterplatte 26 angeordnet. Auf der Leiterplatte 26 sind mehrere elektrische Kontaktflächen 262 als Teil der kapazitiven Sensorschaltungen und optional eine Auswerteschaltung vorgesehen. Die Auswerteschaltung kann wahlweise auch separat von der Bedieneinrichtung vorgesehen und zum Beispiel in einer Steuerung integriert sein.

Die Bedieneinrichtung 14 weist mehrere kapazitive Sensorelemente 28 auf. Diese Sensorelemente 28 sind zum Beispiel aus einem elektrisch leitfähigen Kunststoff als Spritzgussteile gefertigt, können alternativ aber auch aus einem anderen elektrisch leitfähigen Material wie Metall gefertigt sein. Diese Sensorelemente 28 sind jeweils über ein als Schraubendruckfeder ausgebildetes Federelement 34 aus einem elektrisch leitfähigen Material wie zum Beispiel Metall elektrisch leitend mit den Kontaktflächen 262 der Leiterplatte 26 verbunden.

Die Sensorelemente 28 weisen jeweils einen Kopfabschnitt 281 und einen Kontaktabschnitt 286 auf. Der Kopfabschnitt 281 und der Kontaktabschnitt 286 sind bevorzugt einstückig miteinander ausgebildet. Dabei ist der Kopfabschnitt 281 außerhalb des Gehäuses 24 angeordnet, während der Kontaktabschnitt 286 durch eine Durchgangsöffnung 242 in das Gehäuse 24 hinein ragt.

Die Kopfabschnitte 281 der Sensorelemente 28 liegen jeweils an der Innenseite der Blende 12 an dieser an. Der Kopfabschnitt 281 des Sensorelements 28 bildet jeweils die kapazitive Sensorfläche des Bedienelements, welche zusammen mit einem Finger eines Benutzers auf der anderen Seite der Blende 12 eine Kapazität bildet, deren Kapazitätswert variabel ist, wobei die Blende 12 und die Abdeckung 16 als Dielektrikum dienen. Über den Kontaktabschnitt 286 und das Federelement 34 ist der Kopfabschnitt 281 des Sensorelements 28 elektrisch leitend mit einer Kontaktfläche 262 der Leiterplatte 26 verbunden.

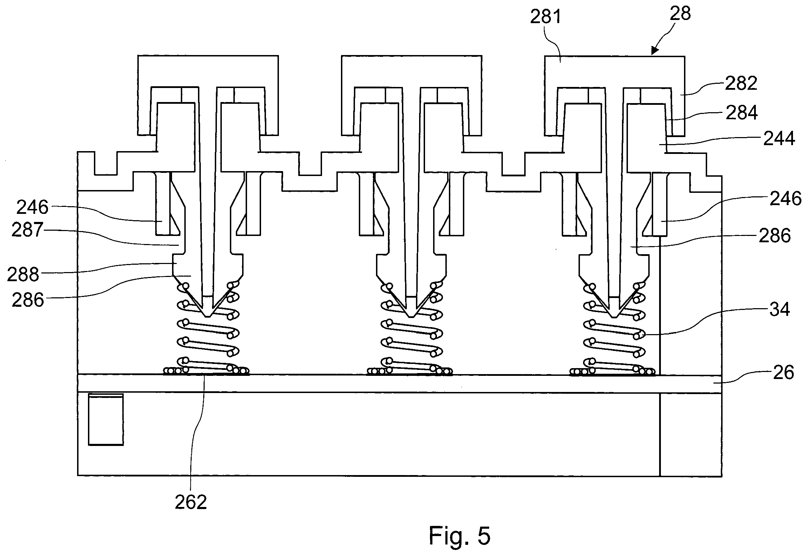

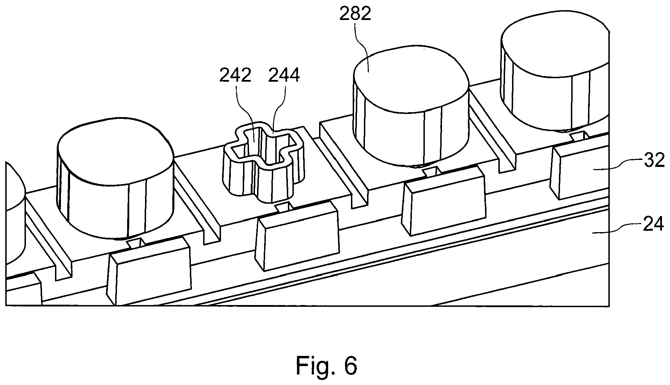

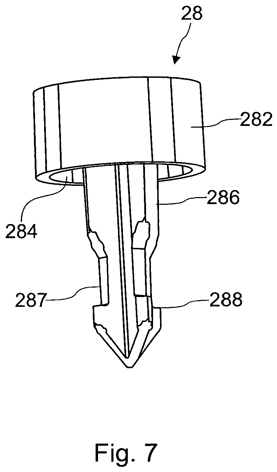

Wie insbesondere in Fig. 5 und 7 zu erkennen, hat der Kontaktabschnitt 286 des Sensorelements 28 zum Beispiel einen im Wesentlichen sternförmigen Querschnitt. Das Gehäuse 24 hat entsprechend sternförmig ausgebildete Durchgangsöffnungen 242, durch welche der Kontaktabschnitt 286 in das Innere des Gehäuses 24 hinein ragt (vgl. Fig. 6).

Das Gehäuse 24 hat zudem um jede Durchgangsöffnung 242 herum einen umlaufenden Vorsprung 244, der in Richtung zur Blende 12 ragt (vgl. Fig. 5 und 6). Der Kopfabschnitt 281 des Sensorelements 28 besitzt einen umlaufenden Vorsprung 282, welcher in Richtung zum Gehäuse 24 ragt. Dabei ist der Vorsprung 282 des Kopfabschnitts 281 radial außerhalb des Vorsprungs 244 des Gehäuses 24 positioniert und vom zentralen Kontaktabschnitt 286 durch einen Hinterschnitt 284 in radialer Richtung beabstandet. Diese beiden Vorsprünge 244, 282 bilden eine Art Labyrinthdichtung um die Durchgangsöffnung 242 im Gehäuse 24 herum.

Ferner haben die radial vorstehenden Leisten des Kontaktabschnitts 286 jeweils eine Rastausnehmung 287, die sich über eine gewisse Länge in der Längsrichtung (Oben(Unten-Richtung in Fig. 5 und 7) des Kontaktabschnitts 286 erstreckt. Im Innern des Gehäuses 24 sind für jede Durchgangsöffnung 242 zwei oder vier Rasthaken 246 vorgesehen, welche in die Rastausnehmungen 287 des Kontaktabschnitts 286 des Sensorelements 28 eingreifen. Die ineinander greifenden Rasthaken 246 und Rastausnehmungen 286 halten das Sensorelement 28 am Gehäuse 24 verliersicher fest und bestimmen einen möglichen Hub des Sensorelements 28 in der Durchgangsöffnung 242 relativ zum Gehäuse 24.

Das untere Ende der Rastausnehmungen 287 des Kontaktabschnitts 286 ist durch einen Vorsprung in Form einer radialen Aufweitung 288 gebildet. Zum einen sitzt der Kontaktabschnitt 286 mit diesem Vorsprung 288 auf dem Federelement 34 auf und kontaktiert dieses. Andererseits begrenzt dieser Vorsprung 288 die Bewegung des Sensorelements 28 in Richtung zur Blende 12 und aus dem Gehäuse 24 heraus. Die Bewegung des Sensorelements 28 nach unten in Richtung weg von der Blende 12 wird durch die Vorsprünge 244, 282 begrenzt.

In diesem Ausführungsbeispiel haben die Sensorelemente 28 jeweils einen Kopfabschnitt 281 mit einer im Wesentlichen Kreisform. Die Form und die Größe der Kopfabschnitte 281 bestimmen Form und Größe der zugehörigen Berührungsfelder auf der Außenseite der Blende 12. Die Kopfabschnitte 281 können grundsätzlich beliebige Formen und Größen besitzen und sind insbesondere nicht auf das in den Figuren gezeigte Ausführungsbeispiel beschränkt.

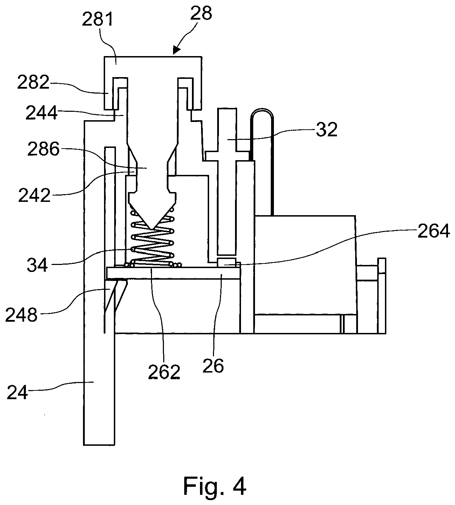

Wie in Fig. 3 und 4 dargestellt, sind auf der Leiterplatte 26 neben den elektrischen Kontaktflächen 262 für die Sensorelemente 28 zumindest in einigen Fällen Leuchtelemente 264 in Form von zum Beispiel Leuchtdioden oder Leuchtdiodengruppen angeordnet. An diese Leuchtelemente 264 grenzt jeweils ein Lichtleiter 32 an (mit oder ohne Abstand), der sich in Richtung zur Blende 12 erstreckt. Die Lichtleiter 32 ragen durch eine Durchgangsöffnung aus dem Gehäuse 24 heraus. Dabei sind die Lichtleiter 32 vorzugsweise fest in das Gehäuse 24 eingesetzt (z.B. gepresst oder geklebt).

In dem gezeigten Ausführungsbeispiel sind die Lichtleiter 32 miteinander gruppenweise verbunden, um das Handling zu vereinfachen. In anderen Ausführungsformen können die Lichtleiter 32 aber auch einzeln gefertigt und in das Gehäuse 24 eingesetzt sein.

In dem gezeigten Ausführungsbeispiel sind die Lichtleiter 32 im Vergleich zu den Kopfabschnitten 281 der Sensorelemente 28 etwas zurückgesetzt, wie zum Beispiel in Fig. 4 dargestellt. In anderen Ausführungsformen können die Lichtleiter 32 je nach Ausgestaltung der Blende 12 und des Gehäuses 24 aber auch die Sensorelemente 28 überragen oder im Wesentlichen in einer Ebene mit deren Kopfabschnitten 281 enden.

Mit den Leuchtelementen 264 und den Lichtleitern 32 können dem Benutzer optische Signale neben den Berührungsfeldern der Sensortasten 28 gegeben werden. Mit diesen optischen Signalen können zum Beispiel die Berührungsfelder gekennzeichnet werden und/oder die Zustände der Bedienelemente (z.B. mittels verschiedener Farben) angezeigt werden.

Wie in Fig. 3, 8 und 9 veranschaulicht, enthält die Bedienvorrichtung 10 in diesem Ausführungsbeispiel zudem ein Anzeigeelement 30 in Form eines elektronischen Displays. Dieses Anzeigeelement 30 ist in diesem Ausführungsbeispiel beispielhaft zwischen zwei Reihen Bedienelementen mittig in der Bedienvorrichtung 10 vorgesehen. Mit Hilfe des Anzeigeelements 30 können dem Benutzer zum Beispiel verschiedene Informationen angezeigt werden, wie beispielsweise der Betriebszustand des Haushaltsgerätes, das ausgewählte Wasch/Spülprogramm, die (Rest-)Dauer des ausgewählten Wasch/Spülprogramms und dergleichen.

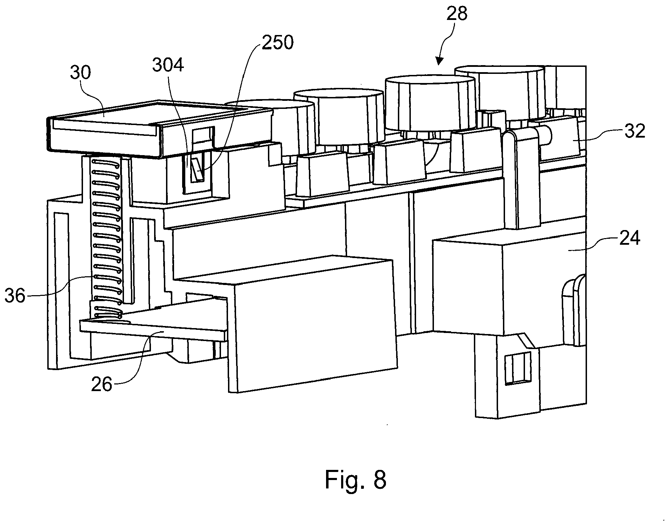

Wie die Sensorelemente 28 ist auch das Anzeigeelement 30 bewegbar an dem Gehäuse 24 der Bedieneinrichtung 14 befestigt. Zu diesem Zweck sind an dem Gehäuse 302 des Anzeigeelements 30 mehrere Haltelaschen 304 vorgesehen, welche in Richtung zum Gehäuse 24 ragen und mit am Gehäuse 24 angebrachten Rastnasen 250 in Eingriff gebracht werden (vgl. Fig. 8).

Zudem sind an der dem Gehäuse 24 zugewandten Unterseite des Gehäuses 302 des Anzeigeelements 30 mehrere Federlaschen 306 vorgesehen, welche das Anzeigeelement 30 von dem Gehäuse 24 weg drücken.

Ferner ist ein weiteres Federelement 36 in Form einer Schraubendruckfeder vorgesehen, welches sich auf einer weiteren elektrischen Kontaktfläche 266 der Leiterplatte 26 abstützt und sich durch eine Durchgangsöffnung im Gehäuse 24 hindurch zum Anzeigeelement 30 erstreckt. Wenn das Federelement 36 aus einem elektrisch leitfähigen Material gefertigt ist, kann es gleichzeitig zur elektrischen Kontaktierung des Anzeigeelements 30 dienen. Außerdem spannt das weitere Federelement 36 das Anzeigeelement 30 in Richtung zur Blende 12 vor.

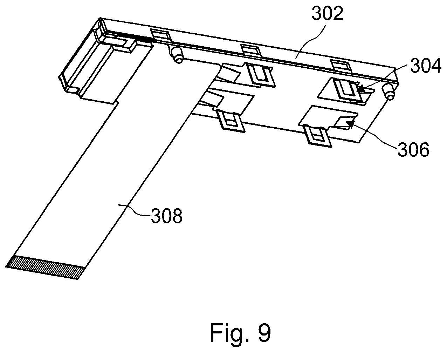

Wie in Fig. 3 und 9 dargestellt, weist das Anzeigeelement 30 ferner eine elektrisch leitfähige Kontaktzunge 308 auf, mit welcher das Anzeigeelement 30 mit der Leiterplatte 26 elektrisch leitend verbunden wird. Diese Kontaktzunge 308 dient zum Beispiel der Erdung des Anzeigeelements 30. In ähnlicher Weise kann das Anzeigeelement 30 auch ein Datenkabel aufweisen (nicht dargestellt), welches mit der Leiterplatte 26 verbunden ist.

### BEZUGSZIFFERNLISTE

- 10: Bedienvorrichtung
- 12: Blende
- 14: Bedieneinrichtung, Bedienmodul
- 16: Abdeckung
- 18: elektrische Anschlüsse
- 20: Öffnung
- 22: Öffnung
- 24: Gehäuse
- 242: Durchgangsöffnung
- 244: Vorsprung
- 246: Rasthaken
- 248: Rastnase
- 250: Rastnase
- 26: Leiterplatte
- 262: Kontaktfläche
- 264: Leuchtelement
- 266: weitere Kontaktfläche
- 28: Sensorelement
- 281: Kopfabschnitt
- 282: Vorsprung
- 284: Hinterschnitt
- 286: Kontaktabschnitt
- 287: Rastausnehmung
- 288: Vorsprung
- 30: Anzeigeelement
- 302: Gehäuse
- 304: Haltelasche
- 306: Federlasche
- 308: Kontaktzunge
- 32: Lichtleiter
- 34: Federelement
- 36: weiteres Federelement

## Patentansprüche

1. Bedienvorrichtung (10), insbesondere für ein elektronisches Haushaltsgerät, mit einer Blende (12) und einer Bedieneinrichtung (14), welche auf der dem Benutzer abgewandten Innenseite der Blende (12) angeordnet ist, wobei die Bedieneinrichtung (14) aufweist:
ein Gehäuse (24) aus einem elektrisch isolierenden Material;
wenigstens eine Leiterplatte (26), welche in dem Gehäuse (24) angeordnet ist und wenigstens eine elektrische Kontaktfläche (262) aufweist;
wenigstens ein Sensorelement (28), welches zumindest teilweise aus einem elektrisch leitfähigen Material ausgestaltet ist, wobei das Sensorelement (28) einen außerhalb des Gehäuses (24) angeordneten Kopfabschnitt (281) und einen durch eine Durchgangsöffnung (242) in das Gehäuse (24) hinein ragenden Kontaktabschnitt (286) aufweist, wobei das Sensorelement (28) relativ zum Gehäuse (24) in Längsrichtung seines Kontaktabschnitts (286) bewegbar ist; und
wenigstens ein Federelement (34), welches zumindest teilweise aus einem elektrisch leitfähigen Material ausgestaltet ist und zwischen der elektrischen Kontaktfläche (262) und dem Kontaktabschnitt (286) des Sensorelements (28) angeordnet ist, um das Sensorelement (28) elektrisch leitend mit der Kontaktfläche (262) zu verbinden und das Sensorelement (28) in Richtung zur Blende (12) vorzuspannen
**dadurch gekennzeichnet, dass**
um die Durchgangsöffnung (242) des Gehäuses (24) herum eine Labyrinthdichtung gebildet ist, welche einen Vorsprung (244) am Gehäuse (24), welcher die Durchgangsöffnung (242) umlaufend in Richtung zur Blende (12) vorsteht, und einen umlaufenden Vorsprung (282) am Kopfabschnitt (281) des Sensorelements (28), welcher in Richtung zum Gehäuse (24) vorsteht und in radialer Richtung innerhalb oder außerhalb des Vorsprunges (244) am Gehäuse (24) positioniert ist, aufweist, wobei der Vorsprung (244) am Gehäuse (24) und der Vorsprung (282) am Kopfabschnitt (281) des Sensorelements (28) ineinander greifen.

2. Bedienvorrichtung nach Anspruch 1,
**dadurch gekennzeichnet, dass**
die wenigstens eine Leiterplatte (26) mehrere elektrische Kontaktflächen (262) aufweist;
mehrere Sensorelemente (28) vorgesehen sind, welche jeweils zumindest teilweise aus einem elektrisch leitfähigen Material ausgestaltet sind, wobei die Sensorelemente (28) jeweils einen außerhalb des Gehäuses (24) angeordneten Kopfabschnitt (281) und einen durch eine Durchgangsöffnung (242) in das Gehäuse (24) hinein ragenden Kontaktabschnitt (286) aufweisen, wobei die Sensorelemente (28) jeweils relativ zum Gehäuse (24) in Längsrichtung ihrer Kontaktabschnitte (286) bewegbar sind; und mehrere Federelemente (34) vorgesehen sind, welche jeweils zumindest teilweise aus einem elektrisch leitfähigen Material ausgestaltet sind und jeweils zwischen einer elektrischen Kontaktfläche (262) und dem Kontaktabschnitt (286) eines Sensorelements (28) angeordnet sind, um das jeweilige Sensorelement (28) elektrisch leitend mit der Kontaktfläche (262) zu verbinden und das Sensorelement (28) in Richtung zur Blende (12) vorzuspannen.

3. Bedienvorrichtung nach einem der vorhergehenden Ansprüche,
**dadurch gekennzeichnet, dass**
das Gehäuse (24) wenigstens ein erstes Rastelement (246) aufweist und der Kontaktabschnitt (286) des Sensorelements (28) wenigstens ein zweites Rastelement (287, 288) aufweist, wobei das erste Rastelement mit dem zweiten Rastelement derart in Eingriff steht, dass das Sensorelement (28) relativ zum Gehäuse (24) in Längsrichtung seines Kontaktabschnitts (286) bewegbar ist.

4. Bedienvorrichtung nach einem der vorhergehenden Ansprüche,
**dadurch gekennzeichnet, dass**
auf der wenigstens einen Leiterplatte (26) wenigstens ein Leuchtelement (264) angeordnet ist; und
in dem Gehäuse (24) wenigstens ein Lichtleiter (32) angeordnet ist, welcher sich von dem Leuchtelement (264) in Richtung zur Blende (12) erstreckt.

5. Bedienvorrichtung nach Anspruch 4,
**dadurch gekennzeichnet, dass**
das Leuchtelement (264) neben einer elektrischen Kontaktfläche (262) auf der Leiterplatte (26) angeordnet ist; und
die Blende (12) in einem Bereich (22) neben dem Kopfabschnitt (281) des Sensorelements (28) zumindest teilweise lichtdurchlässig ausgebildet ist.

6. Bedienvorrichtung nach einem der vorhergehenden Ansprüche,
**dadurch gekennzeichnet, dass**
wenigstens ein Anzeigeelement (30) auf der dem Benutzer abgewandten Seite eines zumindest teilweise lichtdurchlässigen Bereichs (20) der Blende (12) angeordnet und mittels wenigstens eines weiteren Federelements (36) in Richtung zur Blende vorgespannt ist.

7. Bedienvorrichtung nach Anspruch 6,
**dadurch gekennzeichnet, dass**
das Anzeigeelement (30) zwischen dem Gehäuse (24) und der Blende (12) angeordnet ist.

8. Bedienvorrichtung nach Anspruch 7,
**dadurch gekennzeichnet, dass**
das weitere Federelement (36) zumindest teilweise aus einem elektrisch leitfähigen Material ausgestaltet ist und sich auf einer weiteren elektrischen Kontaktfläche (266) der Leiterplatte (26) abstützt, um das Anzeigeelement (30) elektrisch leitend mit der Kontaktfläche (266) zu verbinden.

9. Elektronisches Haushaltsgerät, insbesondere wasserführendes elektronisches Haushaltsgerät, mit wenigstens einer Bedienvorrichtung (10) nach einem der vorhergehenden Ansprüche.

## Claims

1. Operator control apparatus (10), in particular for an electronic household appliance, having a faceplate (12) and having an operator control device (14) which is arranged on the inner side, averted from the user, of the faceplate (12), wherein the operator control device (14) has:
a housing (24) composed of electrically insulating material;
at least one circuit board (26) which is arranged in the housing (24) and which has at least one electrical contact surface (262);
at least one sensor element (28) which is formed at least partially from an electrically conductive material, wherein the sensor element (28) has a head portion (281) arranged outside the housing (24) and has a contact portion (286) which projects through a passage opening (242) into the housing (24), wherein the sensor element (28) is movable in a longitudinal direction of its contact portion (286) relative to the housing (24); and
at least one spring element (34) which is formed at least partially from an electrically conductive material and which is arranged between the electrical contact surface (262) and the contact portion (286) of the sensor element (28) in order to connect the sensor element (28) in electrically conductive fashion to the contact surface (262) and preload the sensor element (28) in the direction of the faceplate (12),
**characterized in that**
a labyrinth seal is formed around the passage opening (242) of the housing (24), which labyrinth seal has a projection (244) on the housing (24), which projection protrudes, so as to encircle the passage opening (242), in the direction of the faceplate (12), and which labyrinth seal has an encircling projection (282) on the head portion (281) of the sensor element (28), which projection protrudes in the direction of the housing (24) and is positioned in a radial direction inside or outside the projection (244) on the housing (24), wherein the projection (244) on the housing (24) and the projection (282) on the head portion (281) of the sensor element (28) engage into one another.

2. Operator control apparatus according to Claim 1,
**characterized in that**
the at least one circuit board (26) has multiple electrical contact surfaces (262);
multiple sensor elements (28) are provided, which are each formed at least partially from an electrically conductive material, wherein the sensor elements (28) each have a head portion (281) arranged outside the housing (24) and a contact portion (286) protruding through a passage opening (242) into the housing (24), wherein the sensor elements (28) are each movable in a longitudinal direction of their contact portions (286) relative to the housing (24); and
multiple spring elements (34) are provided, which are each formed at least partially from an electrically conductive material and are each arranged between an electrical contact surface (262) and the contact portion (286) of a sensor element (28) in order to connect to the respective sensor element (28) in electrically conductive fashion to the contact surface (262) and preload the sensor element (28) in the direction of the faceplate (12).

3. Operator control apparatus according to any of the preceding claims,
**characterized in that**
the housing (24) has at least one first detent element (246) and the contact portion (286) of the sensor element (28) has at least one second detent element (287, 288), wherein the first detent element engages with the second detent element such that the sensor element (28) is movable in a longitudinal direction of its contact portion (286) relative to the housing (24).

4. Operator control apparatus according to any of the preceding claims,
**characterized in that**
at least one luminaire element (264) is arranged on the at least one circuit board (26); and
at least one light conductor (32) is arranged in the housing (24), which light conductor extends from the luminaire element (264) in the direction of the faceplate (12).

5. Operator control apparatus according to Claim 4,
**characterized in that**
the luminaire element (264) is arranged adjacent to an electrical contact surface (262) on the circuit board (26); and
the faceplate (12) is of at least partially translucent form in a region (22) adjacent to the head portion (281) of the sensor element (28).

6. Operator control apparatus as claimed in any of the preceding claims,
**characterized in that**
at least one display element (30) is arranged on that side of an at least partially translucent region (20) of the faceplate (12) which is averted from the user, and said at least one display element is preloaded in the direction of the faceplate by means of at least one further spring element (36).

7. Operator control apparatus according to Claim 6,
**characterized in that**
the display element (30) is arranged between the housing (24) and the faceplate (12).

8. Operator control apparatus according to Claim 7,
**characterized in that**
the further spring element (36) is formed at least partially from an electrically conductive material and is supported on a further electrical contact surface (266) of the circuit board (26) in order to connect the display element (30) in electrically conductive fashion to the contact surface (266).

9. Electronic household appliance, in particular water-carrying electronic household appliance, having at least one operator control apparatus (10) as claimed in any of the preceding claims.

## Revendications

1. Arrangement de commande (10), notamment pour un appareil ménager électronique, comprenant un bandeau (12) et un dispositif de commande (14), lequel est disposé sur le côté intérieur du bandeau (12) à l'opposé de l'utilisateur, le dispositif de commande (14) comprenant :
un boîtier (24) en un matériau électriquement isolant ;
au moins un circuit imprimé (26) qui est disposé dans le boîtier (24) et qui possède au moins une surface de contact électrique (262) ;
au moins un élément de détection (28) qui est constitué au moins partiellement d'un matériau électriquement conducteur, l'élément de détection (28) possédant une portion de tête (281) disposée à l'extérieur du boîtier (24) et une portion de contact (286) qui fait saillie à l'intérieur du boîtier (24) à travers une ouverture de passage (242), l'élément de détection (28) pouvant être déplacé par rapport au boîtier (24) dans le sens longitudinal de sa portion de contact (286) ; et
au moins un élément ressort (34) qui est constitué au moins partiellement d'un matériau électriquement conducteur et qui est disposé entre la surface de contact électrique (262) et la portion de contact (286) de l'élément de détection (28) afin de relier de manière électriquement condutrice l'élément de détection (28) à la surface de contact (262) et précontraindre l'élément de détection (28) en direction du bandeau (12)
**caractérisé en ce que**
une garniture d'étanchéité en labyrinthe est formée autour de l'ouverture de passage (242) du boîtier (24), laquelle possède, au niveau du boîtier (24), une partie saillante (244) qui fait saillie à la périphérie de l'ouverture de passage (242) en direction du bandeau (12) et, au niveau de la portion de tête (281) de l'élément de détection (28), une partie saillante (282) périphérique qui fait saillie en direction du boîtier (24) et, dans le sens radial, est positionnée à l'intérieur ou à l'extérieur de la partie saillante (244) au niveau du boîtier (24), la partie saillante (244) au niveau du boîtier (24) et la partie saillante (282) au niveau de la portion de tête (281) de l'élément de détection (28) venant en prise l'une dans l'autre.

2. Arrangement de commande selon la revendication 1,
**caractérisé en ce que**
l'au moins un circuit imprimé (26) possède plusieurs surfaces de contact électriques (262) ;
plusieurs éléments de détection (28) sont présents, lesquels sont respectivement constitués au moins partiellement d'un matériau électriquement conducteur, les éléments de détection (28) possédant respectivement une portion de tête (281) disposée à l'extérieur du boîtier (24) et une portion de contact (286) qui fait saillie à l'intérieur du boîtier (24) à travers une ouverture de passage (242), les éléments de détection (28) pouvant respectivement être déplacés par rapport au boîtier (24) dans le sens longitudinal de leurs portions de contact (286) ; et
plusieurs éléments ressorts (34) sont présents, lesquels sont respectivement constitués au moins partiellement d'un matériau électriquement conducteur et sont respectivement disposés entre une surface de contact électrique (262) et la portion de contact (286) d'un élément de détection (28) afin de relier de manière électriquement conductrice l'élément de détection (28) respectif à la surface de contact (262) et précontraindre l'élément de détection (28) en direction du bandeau (12).

3. Arrangement de commande selon l'une des revendications précédentes, **caractérisé en ce que** le boîtier (24) possède au moins un premier élément d'encliquetage (246) et la portion de contact (286) de l'élément de détection (28) possède au moins un deuxième élément d'encliquetage (287, 288), le premier élément d'encliquetage étant en prise avec le deuxième élément d'encliquetage de telle sorte que l'élément de détection (28) peut être déplacé par rapport au boîtier (24) dans le sens longitudinal de sa portion de contact (286).

4. Arrangement de commande selon l'une des revendications précédentes, **caractérisé en ce que**
au moins un élément luminescent (264) est disposé sur l'au moins un circuit imprimé (26) ; et
au moins une fibre optique (32) est disposée dans le boîtier (24), laquelle s'étend depuis l'élément luminescent (264) en direction du bandeau (12).

5. Arrangement de commande selon la revendication 4, **caractérisé en ce que**
l'élément luminescent (264) est disposé sur le circuit imprimé (26) à côté d'une surface de contact électrique (262) ; et
le bandeau (12) est réalisé au moins partiellement de manière transparente dans une zone (22) à côté de la portion de contact (281) de l'élément de détection (28).

6. Arrangement de commande selon l'une des revendications précédentes, **caractérisé en ce que**
au moins un élément d'affichage (30) est disposé sur le côté à l'opposé de l'utilisateur d'une zone (20) au moins partiellement transparente du bandeau (12) et précontraint en direction du bandeau au moyen d'au moins un élément ressort supplémentaire (36).

7. Arrangement de commande selon la revendication 6, **caractérisé en ce que** l'élément d'affichage (30) est disposé entre le boîtier (24) et le bandeau (12).

8. Arrangement de commande selon la revendication 7, **caractérisé en ce que** l'élément ressort supplémentaire (36) est constitué au moins partiellement d'un matériau électriquement conducteur et s'appuie sur une surface de contact électrique supplémentaire (266) du circuit imprimé (26) afin de relier de manière électriquement conductrice l'élément d'affichage (30) à la surface de contact (266).

9. Appareil ménager électronique, notamment appareil ménager électronique à circulation d'eau, comprenant au moins un arrangement de commande (10) selon l'une des revendications précédentes.
